Europäisches Patentamt

European Patent Office

Office européen des brevets

(19)

(11) Publication number: 0 160 156

A1

# EUROPEAN PATENT APPLICATION

(12)

(21) Application number: 84830134.7

(22) Date of filing: 30.04.84

(51) Int. Cl.⁴: G 01 S 7/02
H 03 D 9/06

(43) Date of publication of application:
06.11.85 Bulletin 85/45

(84) Designated Contracting States:
AT BE CH DE FR GB LI LU NL SE

(71) Applicant: C.C.B. ELECTRONIC COMPANY S.r.l.
Via Borgognissanti, 12
I-50123 Firenze(IT)

(72) Inventor: Cecot, Valfrido
Via Mentana 36/6
I-50013 Campi Bisenzio Firenze(IT)

(72) Inventor: Bartolozzi, Renzo
Via Argomenna 3
I-50065 Pontassieve Firenze(IT)

(74) Representative: Mannucci, Gianfranco, Dott.-Ing.
Ufficio Tecnico Ing. A. Mannucci Via della Scala 4
I-50123 Firenze(IT)

(54) Structure forming transmitting and receiving cavities placed side by side for microwaves.

(57) A structure forming flattened cavities (A, B) one which transmits and the other which receives, for microwaves – placed side by side, the dimensions of said cavities in the section parallel to the greater sides of the openings being almost square, i.e. the depth being substantially equal to the greater transversal dimension; the surfaces of th components in said cavities are gilded.

Fig.1

EP 0 160 156 A1

STRUCTURE FORMING TRANSMITTING AND RECEIVING CAVITIES

PLACED SIDE BY SIDE FOR MICROWAVES.

The invention has for its object a structure for transmitting and receiving cavities for microwaves, improved so as to obtain particular aims and advantages which will become obvious to specialists reading the following text .

According to the invention a structure forming flattened cavities - one which transmits and the other which receives - for microwaves provides: that the two cavities should be placed side by side (instead of being contiguous and  coplanar); that the sections of said cavities in the section parallel to the greater sides of the openings should be substantially square,

0160156

i.e. the depth should be substantially equal to the greater transversal dimension, or that the surfaces of the components in said cavities should be gilded.

In practice the structure comprises: two parts which are symmetrical and symmetrically applied relative to a third part with a dividing central partition; a bottom wall applied against the assembled first three parts, and fixing means for said parts and means for the engagement therein of emitting and receiving diodes.

In a practical form of embodiment the receiving diode passes through the respective cavity and is engaged between the central dividing partition and a screwed bush of insulating material; the transmitter diode, on the other hand, is engaged between an insulated bolt support and a wing screw or the like by means of which the pressure exerted on the actual diode is controlled.

The invention will be better understood on the basis of the description and attached drawing which shows a practical non-limitative embodiment of the actual invention. In said drawing:

Figure 1 shows a partially sectioned side view of a structure forming cavities for microwaves according to the invention;

Figs. 2, 3 and 4 show views and sections along lines II-II, III-III and IV-IV of Fig. 1; and

Fig. 5 shows a summarized overall view.

As illustrated in the attached drawing, the complete cavity was designed to operate in a frequency comprised between 8 and 12 ghz and particularly between 9 and 10 ghz (X-band).

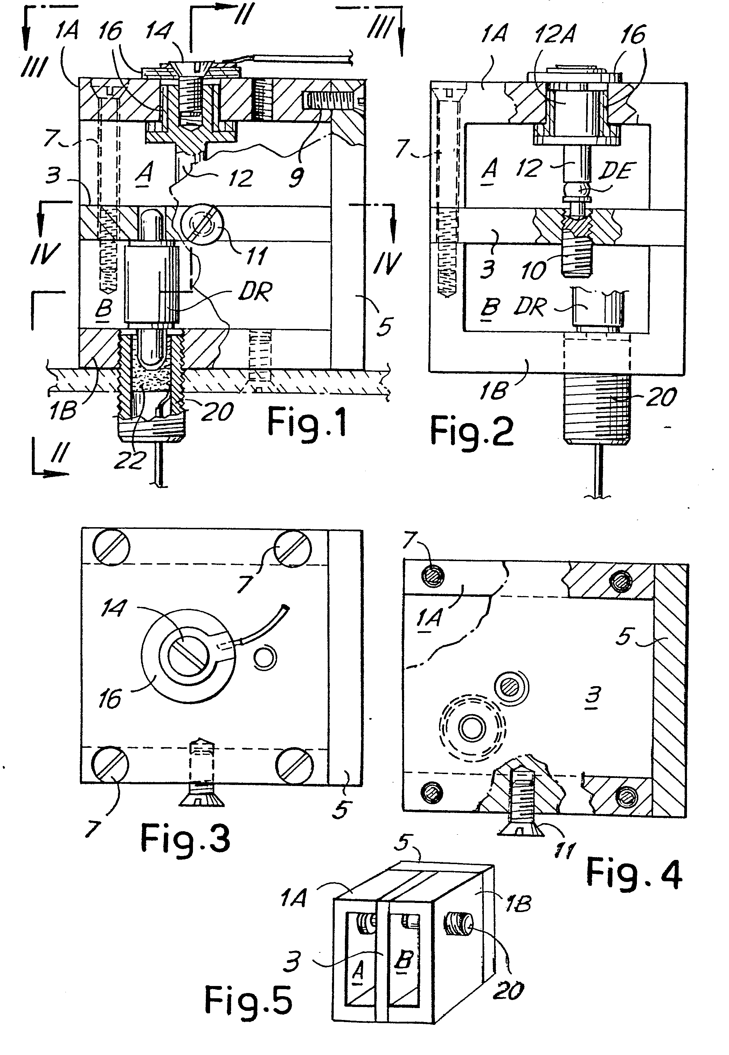

The structure for the formation of cavities for microwaves comprises two parts 1A, 1B which are symmetrical and U-shaped situated on opposite sides of a central wall 3. The figure 5 denotes a bottom wall closing the symmetrical U's A and B which are defined by the above-described components and are open at one end. 7 denotes four screws for coupling between the two parts 1A, 1B for clamping between them the central wall 3 through which said screws pass. 9 denote screws for the fixing of the bottom part 5. 11 denotes at least one screw for the application face to face of the dividing central partition 3. Provision may be made for other screws for application in another position.

The dimension of the cavities A and B in the transversal section relative to the direction of the openings of the actual cavities is rectangular, with the greater dimension of the one parallel with that of the other, the two cavities being side by side and not coplanar. The overall size of the cavities and of the structure which constitutes them is substantially square instead of elongated in depth (relative to the cavities).

Characteristically and advantageously the components 1A, 1B, 3 and 5 are of gilded metal instead of being merely polished.

Cavity A is emitting, and DE indicates the emitting diode housed in same. This diode DE is set between a screwed support 10 mounted on the central wall 3 and a stud support 12 mounted on part 1A through its own flanged base 12A; the latter is housed in a seat of part 1A and then clamped by means of a screw 14 with the interposition of insulating elements 16. The emitting diode DE is controllable as regards compression by means of the screw 1o which is easily operated by means of an L-shaped spanner. Cavity B is the receiving cavity which houses the receiving diode DR in a position transversal relative to the smaller dimension of the actual cavity. The receiving diode DR is housed in a seat formed in the central partition 3 and in a seat formed in a threaded tubular bushing 20 engaged in the part 1B and made of insulating material (Teflon or other), perforated and with an internal contact 22 for electric connection between the diode DR and the circuit.

The structure described is easily taken down, and on account of this it is possible to replace damaged or useless components without any need to replace the whole. The cavities for microwaves produced as described and illustrated are particularly efficient in their operation. Inter alia, the following advantages are particularly obtained: containing the temperature (at most

below 40°C) as compared with the traditional solutions;  a greater stability in operational frequency, mostly attributable to gilding and to the proportion between the various dimensions;  possibility of easy taking down and replacement only in part and limited to wearing parts.

In addition the possibility is afforded of regulating the range of the microwave beam which may be comprised between 1 m and 15 m approximately.

A microwave cavity construxted according to the invention is particularly suitable for disclosing the presence of personnel even only through the breathing movements or slow motion.  The applications may be very diverse, for example, and in particular, for the automatic switching on of lighting appliances only when personnel is present, in museums, public telephone call boxes and others.

It will be understood that the drawing shows only an example given only as a practical demonstration of the invention, while said invention may vary as to form and arrangement without otherwise departing from the scope of he concept at the basis of the actual invention.

0160156

## CLAIMS

1. A structure forming flattened cavities, one which transmits, and the other which receives, for microwaves, characterized by the fact that the two cavities are side by side (instead of contiguous and coplanar), that the sections of said cavities in the section parallel to the greater sides of the openings are substantially square, i.e. the depth is substantially equal to the greater transversal dimension, and that the surfaces of the components in said cavities are gilded.

2. A structure according to the foregoing claim, characterized in that it comprises: two parts which are symmetrical and symmetrically applied relative to a third part with dividing central partition, a bottom wall applied against the assembled first three parts, and means for fixing said parts and for the engagement therein of the emitting and receiving diodes.

3. A structure according to the foregoing claims, characterized in that the receiving diode passes through the appropriate cavity and is engaged between the central dividing partition and a screwed bushing of insulating material.

4. A structure according to the foregoing claims, characterized in that the emitting diode is engaged between an insulated stud support and a wing screw or the like, by means of which the pressure exerted on the actual diode is controlled.

5. A structure according to the foregoing claims, characterized in that it operates on frequencies within the range of 8 to 12 GHz and particularly between 9 and 10 GHz.

6. A structure according to the foregoing claims, characterized in that the receiving diode DR is designed with a tubular bushing with internal contact.

7. A structure forming transmitting and receiving cavities disposed side by side for microwaves, the whole as described and represented.

Fig.1

Fig.2

Fig.3

Fig.4

Fig.5

## EUROPEAN SEARCH REPORT

European Patent
Office

# DOCUMENTS CONSIDERED TO BE RELEVANT

| Category | Citation of document with indication, where appropriate, of relevant passages | Relevant to claim | CLASSIFICATION OF THE APPLICATION (Int. Cl 4) |
|---|---|---|---|
| A | EP-A-0 060 654 (PLESSEY SOUTH AFRICA) <br> * pages 13,14; figures 8,9 * | 1-7 | G 01 S 7/02 <br> H 03 D 9/06 |
| A | US-A-3 636 480 (W.N. HOECK) <br> * column 3, lines 56-59 * | 1 | |
| A | GB-A-1 160 858 (TELEFUNKEN) <br> * page 2, lines 52-64; figure * | 2 | |
| A | US-A-4 157 549 (J.W. DAVIS) <br> * figures 3,6-16 * | 1-7 | |

TECHNICAL FIELDS
SEARCHED (Int. Cl.4)

G 01 S
H 03 D
H 01 Q

The present search report has been drawn up for all claims

| Place of search <br> THE HAGUE | Date of completion of the search <br> 03-01-1985 | Examiner <br> LAUGEL R.M.L. |
|---|---|---|

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO Form 1503. 03.82